# EUROPEAN PATENT SPECIFICATION

(11) **EP 1 211 722 B1**
(45) Date of publication and mention of the grant of the patent: **08.09.2004**
(21) Application number: 01204797.3
(22) Date of filing: 29.11.2001
(51) Int. Cl.: H01L 21/56

(54) **Manufacturing method of electronic device package**
Herstellungsverfahren einer elektronischen Packungsanordnung
Procédé de fabrication d'un empaquetage pour dispositif électronique

(30) Priority: 30.11.2000 EP 00830796
(43) Date of publication of application: 05.06.2002
(73) Proprietor: STMicroelectronics S.r.l., 20041 Agrate Brianza (Milano) (IT)
(72) Inventor: Frezza, Giovanni, 00122 Roma (IT)
(74) Representative: Botti, Mario

(56) References cited:
- EP-A- 0 813 236
- US-A- 4 838 089
- US-A- 4 894 707
- US-A- 5 622 873
- PATENT ABSTRACTS OF JAPAN vol. 016, no. 142 (E-1187), 9 April 1992 (1992-04-09) -& JP 04 002152 A (MITSUBISHI ELECTRIC CORP), 7 January 1992 (1992-01-07)
- PATENT ABSTRACTS OF JAPAN vol. 1998, no. 03, 27 February 1998 (1998-02-27) -& JP 09 304211 A (OMRON CORP), 28 November 1997 (1997-11-28)

## Description

### Application field

This invention relates to a method for forming a protective package for electronic circuits.

Specifically, the invention relates to a method for forming by molding a plastic protective package for an electronic integrated circuit comprising an electronic device activated from the outside of said protective package.

The invention further relates to a plastic protective package for a semiconductor-integrated electronic circuit, comprising a support on which electronic devices like sensors that can be activated from the outside of said protective package are placed.

The invention relates, particularly but not exclusively, to a method for forming a plastic protective package for integrated electronic devices, the package being formed with a window so that the contained electronic devices can at least partially be accessed from the outside of the package, and the following description is made with reference to this application field for convenience of illustration only.

### Prior Art

As it is well known, semiconductor electronic circuits comprising pressure or optical sensors have grown in demand and gained widespread acceptance in recent years.

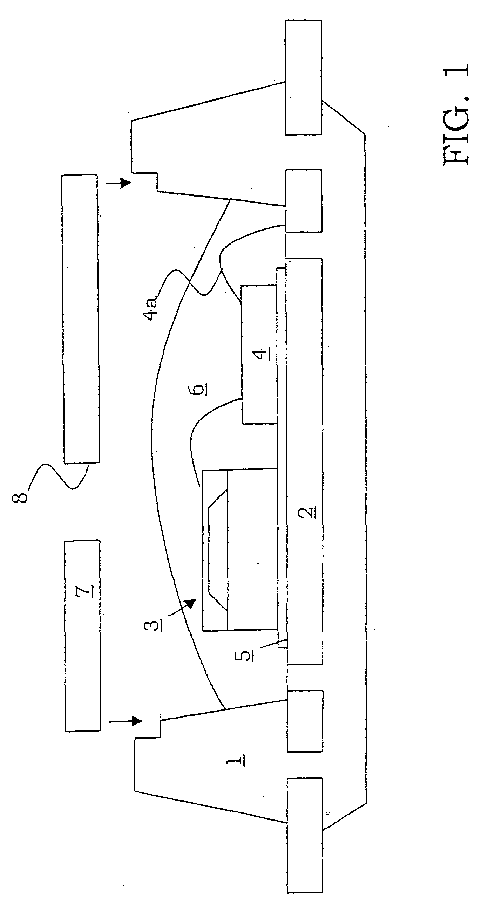

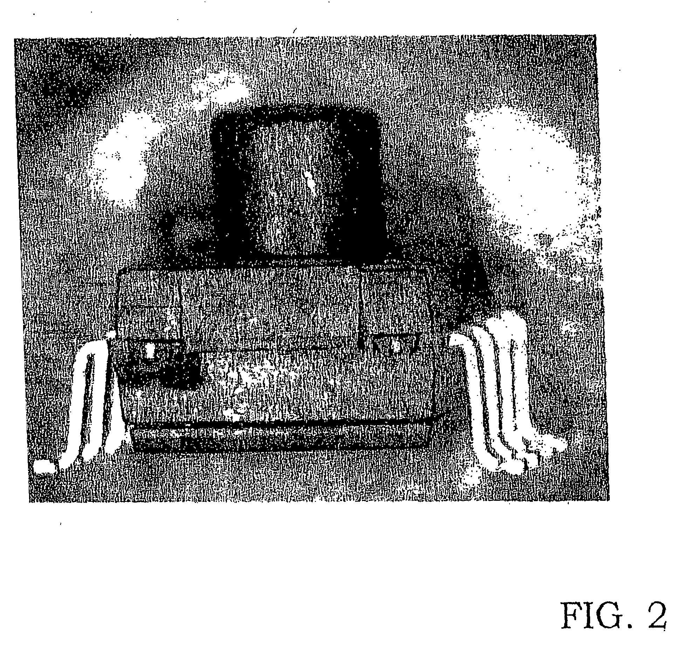

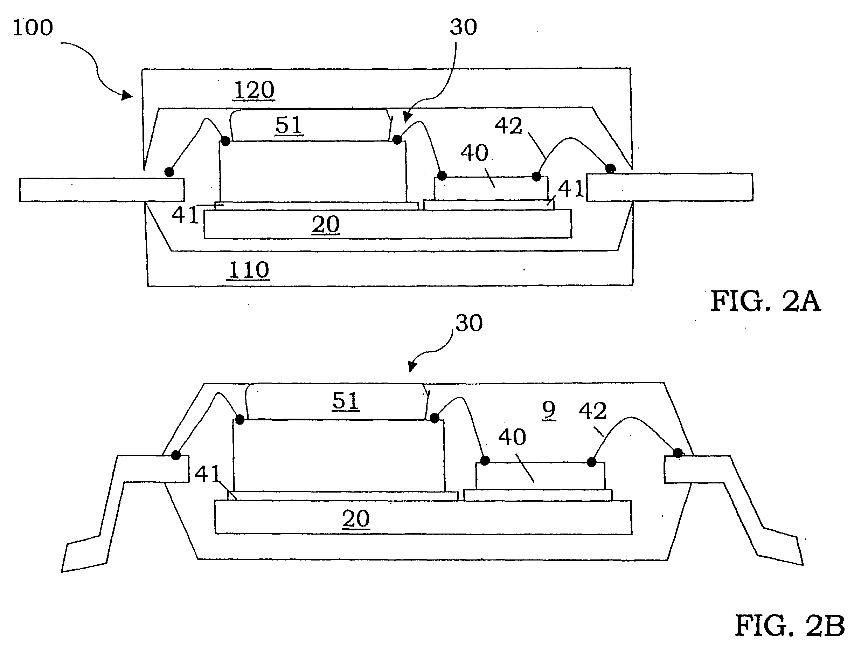

A prior solution for integrating such electronic devices in a package is shown in Figures 1 and 2.

In these figures it is shown, by way of example, a package 1 obtained by a conventional molding technique. This package 1 is substantially tray-like shaped and comprises a support 2 for an integrated circuit.

More particularly, fixed on the support 2 is an integrated circuit comprising a sensor 3, e.g. a proximity or pressure sensor, connected to a control circuitry 4. The circuitry 4 is connected to control pins by thin conductor wires 4a providing an external electrical connection. Both the sensor 3 and the control circuitry 4 are fixed on the support 2 by means of an epoxy adhesive layer 5.

The sensor 3, the circuitry 4 and the support 2 are covered with a coating gel 6.

The package 1 is closed along its edge by a closing element 7 which may be in the form of a window made out of glass, plastic, or another material.

This closing element 7 has a hole 8 aligned to the sensor 3. A pivot is slidingly inserted through this hole 8 to activate the sensor 3 from the outside of the package.

Although in many ways advantageous, this prior solution has some drawbacks. To complete the device, it is necessary firstly to form the package, then insert the components into the package, seal the package, and insert the element for operating the sensor through the package window. Also with such devices, the procedure for aligning and positioning the window to insert the element operating the sensor is troublesome, and this makes the device construction difficult to reproduce. Other known solutions are disclosed in US 5,622,873 and JP 0 402 152 wherein a protection layer is provided over the sensor during the molding step. However, in both solutions this protection layer is removed after molding.

The underlying technical problem of this invention is to provide a method to form package for electronic circuits comprising a sensor that can be activated from the outside of the package, which method has suitable structural and functional features to enable the package being manufactured by conventional molding processes, while overcoming the limitations of the prior art solutions.

The object of this invention is also to provide a mold and an integrated package comprising sensors that can be activated from the outside of the package.

### Summary of the Invention

The resolutive idea of this invention is that to form a package using a conventional molding technique, and provide it with a window aligned to an integrated electronic device, for example a sensor, that is housed inside the package, but in communication with the package exterior. After having fixed the electronic device and control circuit on the support, a surface of the electronic device is covered with a covering layer made out of elastic material so as to form a projecting portion from the device surface. The support is inserted into a mold in such a way that the projecting portion abuts against the superior wall of the mold, when the mold is closed. The mold is then filled with an insulating material to form the package with its window in a single step, with said covering layer being part of the upper that surface of the package.

Based on this resolutive idea, the technical problem is solved by method for forming electronic circuit in a protective package as previously indicated and defined in Claim 1.

The problem is further solved by a package as previously indicated and defined in the characterizing portion of Claim 4.

The features and advantages of the method according to the invention will be apparent from the following description of an embodiment thereof, given by way of example and not of limitation with reference to the accompanying drawings.

### Brief Description of the Drawings

In such drawings:
- Figure 1 is an exploded view schematically showing a protective package for integrated circuits according to the prior art;
- Figure 2 shows a perspective view of a protective package for integrated circuits according to the prior art;
- Figure 2a shows a sectional view of a protective package for integrated circuits during the molding process;
- figure 2b shows a sectional view of an embodiment of a plastic protective package realized with the method according to the invention;
- Figure 3 shows a sectional view of a mold, which is not a part of the claimed invention used in molding a protective package for integrated circuits, at the end of the molding processes, according to the invention;

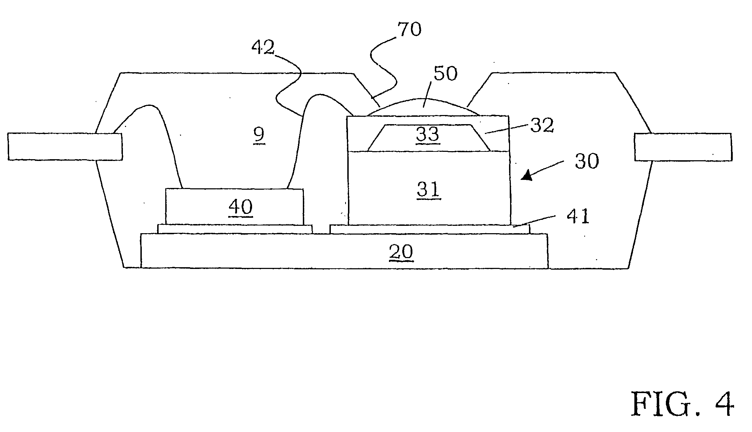

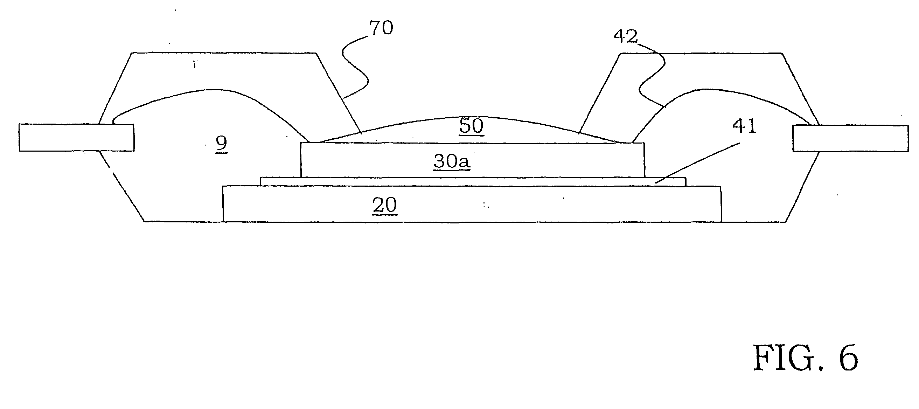

- Figures 4, 5, and 6 are sectional views of examples of a plastic protective package at the end of the molding step which is not a part of the invention.

### Detailed Description

With reference to the drawings, in particular to the examples of Figures 2a and 2b a protective package with a window realized with the method according to this invention, is shown.

Figure 2a shows a vertical section of a single mold delimiting a cavity, although in conventional molding techniques the mold includes a plurality of adjacent dies with mold cavities for simultaneously molding a plurality of packages.

A lead frame or support 20, e.g. in the form of a metal foil, is placed inside the mold cavity. On the lead frame 20 is fixed an electronic circuit comprising an integrated electronic sensor 30, e.g. a proximity sensor of the touch or the optical type. This electronic sensor 30 is fixed to the support 20 by means of a connecting layer 41.

The following description makes reference to these sensor types. Of course, the invention is also applicable to all electronic devices which, although encapsulated within a protective package, should have a surface portion in communication with the package exterior.

According to the invention, a covering layer 50 is provided over the sensor 30. This covering layer 50 may consist of a liquid gel, which is subsequently polymerized and made elastic. A suitable material for this layer 50 may be an elastomer or silicon gel.

According to the invention, this covering layer 50 is shaped so to form a projecting portion 51.

Advantageously, a ring is provided on the cap of the sensor 30, which is formed out of semiconductor material, for example. This ring (not shown) is filled with the covering layer 50 material. Thus, the ring will form a barrage or containing dyke for the covering layer 50.

Advantageously, the covering layer 50 creates a protective layer over the surface of the sensor 30 after the protective package is completed.

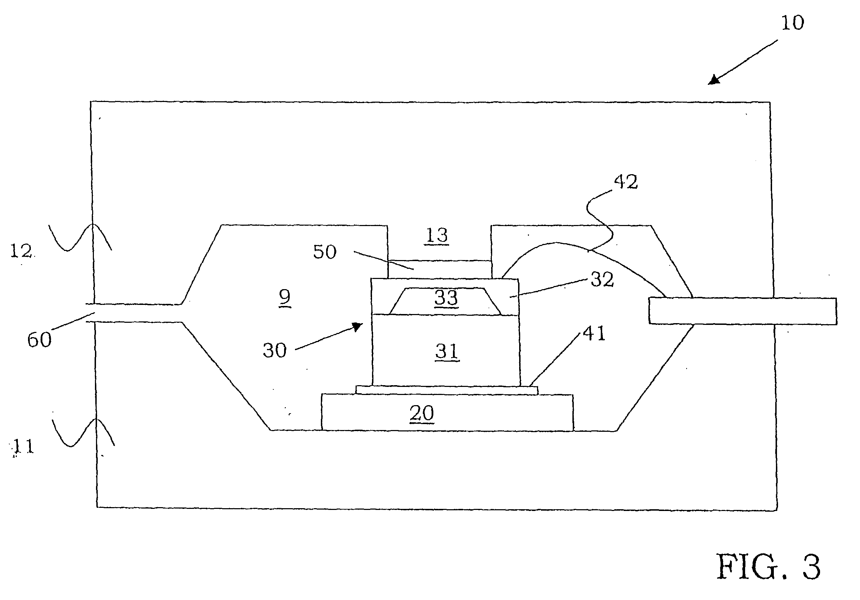

Figure 3 shows an example of a sensor 30 which is not a part of the claimed invention. This sensor 30 may comprise a transparent layer 31, e.g. glass, having a membrane 32 of a semiconductor material laid onto it. This membrane 32 has a concavity arranged to face the transparent layer 31 so as to delimit a recess 33.

Advantageously, the membrane 32 has a substantially flat outward surface.

The method of manufacturing the plastic protective package of this invention will now be described.

Shown at 20 in the figures 2A and 2B is a metal support, e.g. a heat sink, on which a die formed with an inner integrated circuit is mounted.

The integrated circuit comprises a sensor 30 which can be activated from the outside of a protective package 9 and is connected to a control circuitry 40. The circuitry 40 is connected to pins by thin conductor wires 42 providing an external electrical connection.

Advantageously, the support 20 is located on the bottom of the mold cavity of a conventional mold 100, specifically inside the recess formed by the lower half-mold 110.

According to the invention, the surface of the sensor 30 is at least partially coated with a covering layer 50, e.g. a gel comprising an elastomer, or a silicon gel.

Particularly, this covering layer 50 is shaped so to form a projecting portion 51 from the sensor 30.

The formation of such projecting portion 51 is realized by volumetric dispensation on the sensors before that the single device are divided by the wafer or during the mounting step of the circuit.

Alternatively, this projecting portion 51 is formed by a technique know as screen printing that provide a precise shaping of the projecting portion 51.

Advantageously, a dyke, e.g. ring-shaped, is formed on the top surface of the sensor 30. The covering layer 50 is then deposited inside this barrier provided by the dyke, the projecting portion 51 so formed being surrounded by the dyke indeed.

The support 20 is placed into the cavity of the conventional mold 100, and precisely inside the recess of the lower half-mold 110, with the sensor 30 mounted thereon. The pins are laid onto the half-molds 110 outside of the recess.

The upper half-mold 120 is then clamped down onto the lower half-mold 110, so that a containing space is created between the two half-molds 110 and 120 as shown in Figure 2a.

When the upper half-mold 120 clamped onto the lower half-mold 110, the projecting portion 51 abuts against the upper wall of the mold cavity of the closed mold.

According to the invention, the projecting portion 51 protects the sensor 30 from potential damage by the pressure of the upper half-mold 120 against the surface of the sensor 30 when the half-mold 120 is clamped down onto the lower half-mold 110. In fact, the projecting portion 51 provides a cushioning effect.

In particular, with the projecting portion 51 made out of an elastomer or silcon , as the upper half-mold 120 is clamped down onto the lower half-mold 110, the projecting portion 51 cedes to the pressure from half-mold 120 and prevents cracking of the sensor surface.

Once the two half-molds 110 and 120 are clamped together, the step of forming the protective package 9 is carried out.

A plastic material, such as an epoxy resin, is pressure injected, in a molten state at a high temperature, into the mold cavity between the half-molds 110 and 120 through an inlet 60 and runners (not shown).

This is followed by well-known thermodynamic processes for cooling and curing the resin.

As a result of the projecting portion 51 abutting against the upper wall of the upper half-mold 120, the package 10 will ultimately show a hole or a window 70 at the location of the sensor 30.

Alternative embodiments are now disclosed even if they don't fall within the scope of protection of the invention.

In figures 3, an example is shown. A mold 10 essentially comprises two parts: a lower half-mold 11 and an upper half-mold 12. When the two half-molds are clamped together, a space or mold cavity is defined for containing the electronic circuit.

According to this example, the upper half-mold 12 has an internal protruding lug 13 centrally projecting therein, approximately at the location of the sensor 30. This lug 13 is positioned such that, when the half-mold 12 and the lower half-mold 11 are superimposed, the lug 13 will abut against, or at least touch, the sensor covering layer 50.

Advantageously, the lug 13 is substantially shaped cylinder and has the same width as the covering layer 50.

In an alternative example, the lug 13 may be substantially shaped as a truncated conic.

Advantageously, the bottom surface of the lug 13 has a smaller area than the top surface of the sensor, and consequently of the projected portion 51.

So when the upper half-mold 12 is clamped with the lower half-mold 11, the lug 13 is placed such that it is abutted against the projecting portion 51.

Where the lug 13 is shaped as a truncated cone, the window 70 will show with tapering walls toward the sensor 30.

In this example it is only necessary that the projecting portion 51 abuts against the lug 13, so that the formation of the projecting portion 51 is less critical.

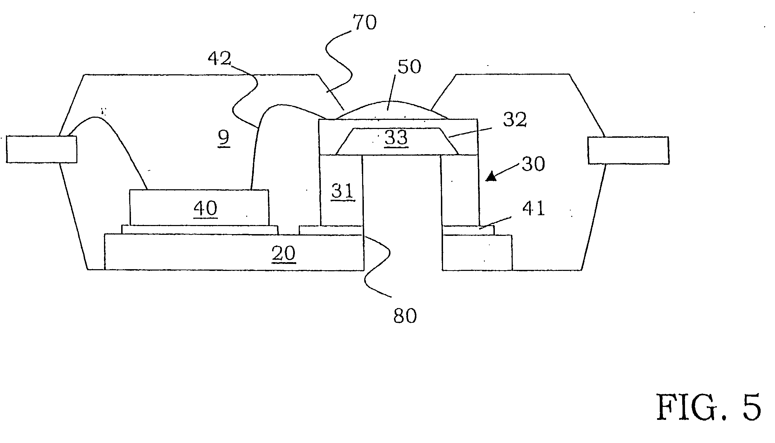

Shown in Figure 5 is a package 9 which has been molded according to an example the invention in the instance of a pressure sensor 30 being integrated therein.

In this case, both the support 20 and the glass layer 31 of the sensor 30 are formed with a hole 80 that opens into the recess 33 under the membrane 32.

Here again, a package 9 having a window 70 aligned to the sensor 30 can be obtained using a convention mold 100 and forming the projecting portion 51 from the sensor 30 or using a mold 10 with a lug 13.

The method of this invention can also advantageously be used with an integrated circuit provided with optical sensors.

In a further example shown in figure 7, an optical sensor 30a is fixed on the support 20.

The sensor 30a is coated with a covering layer 50 before the molding steps to build the protective package 9 according to this invention.

In this example, the covering layer 50 is transparent to UV radiation.

To conclude, the method and the mold according to the invention allows a plastic protective package, integrated with a sensor that can be activated from the outside of the package, to be manufactured by a conventional molding technique.

Electronic devices package obtained by means of the method according to this invention allow a more precise manufacturing processes.

## Claims

1. A method of forming by molding a plastic protective package (9) for a semiconductor integrated electronic circuit comprising an electronic device (30) activated from the outside of said protective package (9) and an integrated control circuit (40), including the following steps:
- providing a support (20) on which are fixed said electronic device (30) and said control circuit (40) connected to said electronic device (30),
- dispensing a covering layer (50) of an elastomer or silicon gel at least over a portion of said electronic device (30) that will be activated from the outside of said protective package (9),
- shaping said covering layer (50) to form a projecting portion (51) having an upper surface opposite a surface of said electronic device (30),
- molding said support, said electronic device (30) and said control circuit (40) using a mold including a half-mold having an internal continuous flat surface of which a portion is abutting against said projecting portion (51) to form said plastic protective package (9), wherein, after molding, the upper flat surface of the protective plastic package (9) is flush and continuous with an upper flat surface of said elastomer or gel with said covering layer (50) acting as a protective layer often the package is completed.

2. A method for forming a plastic protective package (9) according to Claim 1, **characterized in that** said projecting portion (51) is realized by volumetric dispensing of said elastic material.

3. A method for forming a plastic protective package (9) according to Claim 1, **characterized in that** said projecting portion (51) is realized by screen printing of said elastic material.

4. A plastic protective package (9) for a semiconductor integrated circuit, comprising a support (20) whereon an electronic device (30) is fixed together with an integrated control circuit (40) connected to said device (30), wherein said protective package surrounds an elastomer or a silicon gel formed on at least a portion of said electronic device (30) and having a flat upper surface opposite a surface said electronic device (30), which upper flat surface is flush an continuous with an upper flat surface of the plastic protective package (9), with said elastomer on silicon get acting as a protective layer.

5. A plastic protective package according to Claim 4, **characterized in that** said elastomer on slicon gel (51) is surrounded by a dyke formed on the surface of the electronic device (30,30a).

## Patentansprüche

1. Umformverfahren mit Formen einer schützende Bauteilgruppe (9) aus Plastik für eine in einen Halbleiter integrierte elektronische Schaltung, welche ein elektronisches Bauelement (30), das von außerhalb der schützenden Bauteilgruppe (9) aktiviert wird, sowie eine integrierte Steuerschaltung (40) aufweist, wobei das Verfahren die folgenden Schritte umfasst:
- Vorsehen eines Trägers (20), auf dem das elektronische Bauelement (30) und die mit dem elektronischen Bauelement (30) verbundene Steuerschaltung (40) befestigt werden;
- Auftragen einer Abdeckschicht (50) aus einem Elastomer- oder Silikongel zumindest über einen Teil des elektronischen Bauelements (30), das von außerhalb der schützenden Bauteilgruppe (9) aktiviert wird;
- Formung der Abdeckschicht (50) zur Bildung eines vorstehenden Abschnitts (51) mit einer Oberfläche, die einer Fläche des elektronischen Bauelements (30) gegenüber liegt;
- Formen des Trägers, des elektronischen Bauelements (30) und der Steuerschaltung (40) unter Verwendung einer Form, welche eine Formhälfte mit einer innen liegenden durchgehenden flachen Fläche umfasst, von welcher ein Abschnitt gegen den vorstehenden Abschnitt (51) anliegt, um die schützende Bauteilgruppe (9) aus Plastik zu bilden, wobei nach dem Formen die flache Oberfläche der schützenden Bauteilgruppe (9) aus Plastik bündig und zusammenhängend mit einer flachen Oberfläche des Elastomer- oder Gelmaterials abschließt,
wobei die Abdeckschicht (50) nach Fertigstellung der Bauteilgruppe als Schutzschicht fungiert.

2. Verfahren zum Formen einer schützenden Bauteilgruppe (9) aus Plastik nach Anspruch 1, **dadurch gekennzeichnet, dass** der vorspringende Abschnitt (51) durch volumetrisches Auftragen des elastischen Werkstoffs ausgebildet wird.

3. Verfahren zum Formen einer schützenden Bauteilgruppe (9) aus Plastik nach Anspruch 1, **dadurch gekennzeichnet, dass** der vorspringende Abschnitt (51) mittels Siebdrucken des elastischen Werkstoffs ausgebildet wird.

4. Schützende Bauteilgruppe (9) aus Plastik für eine integrierte Halbleiterschaltung, welche einen Träger (20) aufweist, auf welchem ein elektronisches Bauelement (30) zusammen mit einer mit dem elektronischen Bauelement (30) verbundenen integrierten Steuerschaltung (40) befestigt ist, bei welchem die schützende Bauteilgruppe ein Elastomer- oder ein Silikongel umschließt, das auf mindestens einem Abschnitt des elektronischen Bauelements (30) umschließt und eine flache Oberfläche gegenüber eine Fläche des elektronischen Bauelements (30) aufweist, wobei die flache Oberfläche bündig und zusammenhängend mit einer flachen Oberfläche der schützenden Bauteilgruppe (9) abschließt, wobei das Elastomer- bzw. Silikongel als Schutzschicht fungiert.

5. Schützende Bauteilgruppe nach Anspruch 4, **dadurch gekennzeichnet, dass** das Elastomer- bzw. Silikongel (51) von einer Absperrung umschlossen ist, die auf der Oberfläche des elektronischen Bauelements (30, 30a) ausgebildet wird.

## Revendications

1. Procédé de formation par moulage d'un emballage de protection en plastique (9) pour un circuit électronique intégré à semi-conducteurs comprenant un dispositif électronique (30) activé depuis l'extérieur dudit emballage de protection (9) et un circuit de commande intégré (40), comportant les étapes suivantes :
- fournir un support (20) sur lequel sont fixés ledit dispositif électronique (30) et ledit circuit de commande (40) connecté au dit dispositif électronique (30),
- répartir une couche de revêtement (50) d'un élastomère ou d'un gel de silicone sur au moins une partie dudit dispositif électronique (30) qui sera activé depuis l'extérieur dudit emballage de protection (9),
- donner une forme à ladite couche de revêtement (50) afin de former une partie faisant saillie (51), présentant une surface supérieure, opposée à une surface dudit dispositif électronique (30),
- mouler ledit support, ledit dispositif électronique (30) et ledit circuit de commande (40) en utilisant un moule, comportant un demi-moule présentant une surface interne plate continue dont une partie bute contre ladite partie faisant saillie (51) afin de former ledit emballage de protection en plastique (9), dans lequel, après le moulage, la surface plate supérieure de l'emballage de protection en plastique (9) affleure et est continue avec une surface plate supérieure dudit élastomère ou gel, ladite couche de revêtement (50) agissant comme une couche protectrice lorsque l'emballage est terminé.

2. Procédé de formation d'un emballage de protection en plastique (9) selon la revendication 1, **caractérisé en ce que** ladite partie faisant saillie (51) est réalisée grâce à une répartition volumétrique dudit matériau élastique.

3. Procédé de formation d'un emballage de protection en plastique (9) selon la revendication 1, **caractérisé en ce que** ladite partie faisant saillie (51) est réalisée grâce à une impression au cadre dudit matériau élastique.

4. Emballage de protection en plastique (9) pour un circuit intégré à semi-conducteurs, comprenant un support (20) sur lequel un dispositif électronique (30) est fixé avec un circuit de commande intégré (40) connecté au dit dispositif (30), dans lequel ledit emballage de protection entoure un élastomère ou un gel de silicone formé sur au moins une partie dudit dispositif électronique (30) et ayant une surface supérieure plate opposée à une surface dudit dispositif électronique (30), laquelle surface supérieure plate affleure et est continue avec une surface plate supérieure de l'emballage de protection en plastique (9), ledit élastomère ou gel de silicone agissant comme une couche protectrice.

5. Emballage de protection en plastique selon la revendication 4, **caractérisé en ce que** ledit élastomère ou gel de silicone (51) est entouré d'une levée formée sur la surface du dispositif électronique (30, 30a).
